# EUROPEAN PATENT APPLICATION

(11) **EP 4 807 382 A1**
(43) Date of publication of application: **16.09.2026**
(21) Application number: 24896626.9
(22) Date of filing: 28.11.2024
(51) Int. Cl.: G01R 31/60

(54) **POWER SUPPLY SYSTEM AND NETWORK DEVICE**

(30) Priority: 30.11.2023 CN 202311647051
(71) Applicant: Huawei Technologies Co., Ltd., Shenzhen, Guangdong 518129 (CN)
(72) Inventor: ZHENG, Guangming, Shenzhen, Guangdong 518129 (CN); TONG, Haifeng, Shenzhen, Guangdong 518129 (CN); YAN, Siyou, Shenzhen, Guangdong 518129 (CN); SONG, Wentao, Shenzhen, Guangdong 518129 (CN); LI, Jiehong, Shenzhen, Guangdong 518129 (CN)
(74) Representative: Isarpatent
(86) International application number: PCT/CN2024/135125
(87) International publication number: WO 2025/113540

(57) **Abstract**

A power system and a network device are provided, to acquire a second detection voltage (V2) of a first connector (1) based on a first detection voltage (V1) provided by a voltage source (Vcc), so that a type of a power cable (L1) is identified based on the second detection voltage (V2), thereby ensuring reliability of the power cable (L1) and avoiding an increase in operation and maintenance costs of the network device. The power system (20) includes a power module (PM). The power module (PM) includes the voltage source (Vcc), a sampling circuit (AD), and the first connector (1). The first connector (1) is configured to connect to the power cable (L1), and the power cable (L1) is connected to a power supply (PS1). The voltage source (Vcc) is configured to provide the first detection voltage (V1) for the first connector (1). The sampling circuit (AD) is configured to: acquire the second detection voltage (V2) from the first connector (1), and identify the type of the power cable (L1) based on the second detection voltage (V2).

## Description

This application claims priority to Chinese Patent Application No. 202311647051.9, filed with the China National Intellectual Property Administration on November 30, 2023, and entitled "POWER SYSTEM AND NETWORK DEVICE", which is incorporated herein by reference in its entirety.

### TECHNICAL FIELD

This application relates to the field of communication network technologies, and more specifically, to a power system and a network device.

### BACKGROUND

With rapid development of communication network technologies, network devices are widely used. The network device may include a power system and a terminal device. The power system may include a power module. The power module may be connected to a power supply through a power cable, and the power module may further be connected to the terminal device through a cable. The network device has a long service life. When the power module is upgraded within the service life of the network device, the power cable needs to be upgraded synchronously. To ensure compatibility of a power cable socket and avoid incorrect plug-in of the power cable, the power system needs to have a function of identifying a type of the power cable.

In a related technology, an electronic chip and an active component are usually disposed in the power cable. The electronic chip may control the active component to send, to the terminal device, identification information indicating the type of the power cable (for example, a 3 kW power cable, a 4 kW power cable, or a 6 kW power cable), so as to identify the type of the power cable. However, disposing the electronic chip and the active component may increase costs of the power cable. In addition, because the network device needs to run reliably for a long time, and the active component is easy to be damaged, reliability of the power cable is greatly reduced, and operation and maintenance costs of the network device are increased.

Therefore, the power system that can identify the type of the power cable is urgently needed.

### SUMMARY

This application provides a power system and a network device. A second detection voltage of a first connector is acquired based on a first detection voltage provided by a voltage source, so that a type of a power cable is identified based on the second detection voltage, thereby ensuring reliability of the power cable and avoiding an increase in operation and maintenance costs of the network device.

According to a first aspect, this application provides a power system, which may include a power module. The power module may include a voltage source, a sampling circuit, and a first connector. The first connector may be configured to connect to a power cable, and the power cable is connected to a power supply.

The voltage source may be configured to provide a first detection voltage for the first connector.

The sampling circuit may be configured to: acquire a second detection voltage from the first connector, and identify a type of the power cable based on the second detection voltage. The type of the power cable may include a type-A power cable, a type-B power cable, and a type-C power cable. The type-A power cable may be a 4 kW power cable, the type-B power cable may be a 6 kW power cable, and the type-C power cable may be a 3 kW power cable or the like. This is not limited in this application.

According to the power system provided in this application, the second detection voltage of the first connector may be acquired based on the first detection voltage provided by the voltage source, so that the type of the power cable is identified based on the second detection voltage. It can be learned that, in comparison with the related technology in which an electronic chip and an active component are disposed in a power cable, the power system provided in this application implements identification of a type of a power cable, ensures reliability of the power cable, and avoids an increase in operation and maintenance costs of a network device.

Further, the first connector may include a first signal pin and a second signal pin. Alternatively, the first connector may include a first signal pin, a second signal pin, and a third signal pin.

The power cable may include a second connector, and the second connector may be configured to connect to the first connector.

The second connector may be configured to short-circuit the first signal pin and the second signal pin. Alternatively, the second connector may be configured to short-circuit the third signal pin and the second signal pin.

The power system provided in this application may have a single power entry scenario and a multi-power entry scenario (for example, a dual power entry scenario). In the single power entry scenario, the power system is connected to one power cable through the first connector, and is configured to identify a type of the single power cable. In the multi-power entry scenario, the power system is connected to a plurality of power cables (for example, two power cables) through the first connector, and is configured to identify types of the plurality of power cables. In other words, the power system provided in this application may identify the type of the single power cable through the first connector, or may identify the types of the plurality of power cables through the first connector.

In a possible implementation, when the power system is configured to identify a type of a single power cable, the power module may further include a first voltage divider resistor.

Optionally, a first end of the first voltage divider resistor is connected to the voltage source. A second end of the first voltage divider resistor may be connected to the sampling circuit. The second end of the first voltage divider resistor may further be connected to the second connector through the first signal pin of the first connector. The second signal pin of the first connector may be connected to the second connector and is connected to a ground terminal. It can be learned that, the power system provided in this application may identify the types of two types of power cables, for example, a 3 kW power cable and a 4 kW power cable, through the voltage source, the first voltage divider resistor, and the sampling circuit.

In another possible implementation, when the power system is configured to identify types of a plurality of power cables, the power module may include a plurality of first connectors and a plurality of sampling circuits. The plurality of power cables include a plurality of second connectors. The power module may further include a first voltage divider resistor and a second voltage divider resistor.

Respective first ends of the first voltage divider resistor and the second voltage divider resistor may be connected to the voltage source. A second end of the first voltage divider resistor may be connected to a first sampling circuit in the plurality of sampling circuits, and the second end of the first voltage divider resistor may further be connected to one of the second connectors through a first signal pin of one of the first connectors. A second end of the second voltage divider resistor may be connected to a second sampling circuit in the plurality of sampling circuits, and the second end of the second voltage divider resistor may further be connected to another second connector through a first signal pin of another first connector. A second signal pin of the one of the first connectors may be correspondingly connected to the one of the second connectors, a second signal pin of the another first connector may be correspondingly connected to the another second connector, and a second signal pin of each first connector may be connected to the ground terminal. It can be learned that, the power system provided in this application may identify the types of two types of power cables, for example, a 3 kW power cable and a 4 kW power cable, through the voltage source, the first voltage divider resistor, the second voltage divider resistor, the first sampling circuit, and the second sampling circuit.

Further, when the power system is configured to identify a type of a single power cable, the power module may further include a third voltage divider resistor.

Optionally, a first end of the third voltage divider resistor may be connected to the sampling circuit. The first end of the third voltage divider resistor may be connected to the second connector through the first signal pin of the first connector. A second end of the third voltage divider resistor may be connected to the second connector through the third signal pin of the first connector. Alternatively, the first end of the third voltage divider resistor may be connected to the second connector through the third signal pin of the first connector. A second end of the third voltage divider resistor may be connected to the second connector through the first signal pin of the first connector. It can be learned that, the power system provided in this application may identify types of three types of power cables, for example, a 3 kW power cable, a 4 kW power cable, and a 6 kW power cable, through the voltage source, the first voltage divider resistor, the third voltage divider resistor, and the sampling circuit.

Further, when the power system is configured to identify types of a plurality of power cables, the power module may further include a third voltage divider resistor and a fourth voltage divider resistor.

A first end of the third voltage divider resistor may be connected to the first sampling circuit. The first end of the third voltage divider resistor may further be connected to one of the second connectors through the first signal pin of one of the first connectors. A second end of the third voltage divider resistor may be connected to the one of the second connectors through a third signal pin of the one of the first connectors. Alternatively, the first end of the third voltage divider resistor may further be connected to one of the second connectors through a third signal pin of one of the first connectors. A second end of the third voltage divider resistor may be connected to the one of the second connectors through a first signal pin of the one of the first connectors.

A first end of the fourth voltage divider resistor may be connected to the second sampling circuit. The first end of the fourth voltage divider resistor may further be connected to another second connector through a first signal pin of another first connector. A second end of the fourth voltage divider resistor may be connected to the another second connector through a third signal pin of the another first connector. Alternatively, the first end of the fourth voltage divider resistor may further be connected to another second connector through a third signal pin of another first connector. A second end of the fourth voltage divider resistor may be connected to the another second connector through a first signal pin of the another first connector.

It can be learned that, the power system provided in this application may identify the types of three types of power cables, for example, a 3 kW power cable, a 4 kW power cable, and a 6 kW power cable, through the voltage source, the first voltage divider resistor, the second voltage divider resistor, the third voltage divider resistor, the fourth voltage divider resistor, the first sampling circuit, and the second sampling circuit.

In some possible implementations, when the power system is configured to identify a type of a single power cable, the power module may include a plurality of sampling circuits. The power module may further include a first voltage divider resistor and a second voltage divider resistor.

Respective first ends of the first voltage divider resistor and the second voltage divider resistor may be connected to the voltage source. A second end of the first voltage divider resistor is connected to a first sampling circuit in the plurality of sampling circuits, and the second end of the first voltage divider resistor is further connected to the second connector through the first signal pin of the first connector. A second end of the second voltage divider resistor is connected to a second sampling circuit in the plurality of sampling circuits, and the second end of the second voltage divider resistor is further connected to the second connector through the third signal pin of the first connector. The second signal pin of the first connector is connected to the second connector and may be connected to a ground terminal. It can be learned that, the power system provided in this application may identify the types of three types of power cables, for example, a 3 kW power cable, a 4 kW power cable, and a 6 kW power cable, through the voltage source, the first sampling circuit, the second sampling circuit, the first voltage divider resistor, and the second voltage divider resistor.

In some other possible implementations, when the power system is configured to identify types of a plurality of power cables, the power module includes a plurality of first connectors and a plurality of sampling circuits. The plurality of power cables include a plurality of second connectors. The power module further includes a first voltage divider resistor, a second voltage divider resistor, a fifth voltage divider resistor, and a sixth voltage divider resistor.

Respective first ends of the first voltage divider resistor, the second voltage divider resistor, the fifth voltage divider resistor, and the sixth voltage divider resistor are connected to the voltage source. A second end of the first voltage divider resistor is connected to a first sampling circuit in the plurality of sampling circuits, and the second end of the first voltage divider resistor is further connected to one of the second connectors through a first signal pin of one of the first connectors. A second end of the second voltage divider resistor is connected to a second sampling circuit in the plurality of sampling circuits, and the second end of the second voltage divider resistor is further connected to the one of the second connectors through a third signal pin of the one of the first connectors. A second signal pin of the one of the first connectors may be connected to the one of the second connectors and is connected to the ground terminal.

A second end of the fifth voltage divider resistor is connected to a third sampling circuit in the plurality of sampling circuits, and the second end of the fifth voltage divider resistor is further connected to another second connector through a first signal pin of another first connector. A second end of the sixth voltage divider resistor is connected to a fourth sampling circuit in the plurality of sampling circuits, and the second end of the sixth voltage divider resistor is further connected to the another second connector through a third signal pin of the another first connector. A second signal pin of the another first connector may be connected to the another second connector and is connected to the ground terminal.

It can be learned that, the power system provided in this application may identify the types of three types of power cables, for example, a 3 kW power cable, a 4 kW power cable, and a 6 kW power cable, through the voltage source, the first voltage divider resistor, the second voltage divider resistor, the third voltage divider resistor, the fourth voltage divider resistor, the first sampling circuit, the second sampling circuit, the third sampling circuit, and the fourth sampling circuit.

Further, in addition to the power module, the power system may further include a power entry module (power entry module, PEM). The power entry module includes a third connector and a fourth connector.

The third connector may be configured to connect to the first connector, and the fourth connector may be configured to connect to the second connector.

In some possible implementations, when the power system is configured to identify a type of a single power cable, the power entry module may include a third connector and a fourth connector. The power module further includes a first voltage divider resistor.

Optionally, a first end of the first voltage divider resistor is connected to the voltage source. A second end of the first voltage divider resistor is connected to the sampling circuit. The second end of the first voltage divider resistor may further be connected to the first signal pin of the first connector. The first signal pin of the first connector is connected to the second connector through a first signal pin of the third connector and a first signal pin of the fourth connector. The second signal pin of the first connector may be connected to the second connector through a second signal pin of the third connector and a second signal pin of the fourth connector, and the second signal pin of the first connector may be connected to a ground terminal. It can be learned that, the power system provided in this application may identify the types of three types of power cables, for example, a 3 kW power cable, a 4 kW power cable, and a 6 kW power cable, through the voltage source, the first voltage divider resistor, the third connector, the fourth connector, and the sampling circuit.

In some other possible implementations, when the power system is configured to identify types of a plurality of power cables, the power entry module includes a third connector and a plurality of fourth connectors, the power module includes a plurality of sampling circuits, the plurality of power cables include a plurality of second connectors, and the power module further includes a first voltage divider resistor and a second voltage divider resistor.

Respective first ends of the first voltage divider resistor and the second voltage divider resistor may be connected to the voltage source. A second end of the first voltage divider resistor may be connected to a first sampling circuit in the plurality of sampling circuits, and the second end of the first voltage divider resistor may further be connected to the first signal pin of the first connector. A second end of the second voltage divider resistor may be connected to a second sampling circuit in the plurality of sampling circuits, and the second end of the second voltage divider resistor is further connected to the third signal pin of the first connector. The first signal pin of the first connector may be connected to one of the second connectors through a first signal pin of the third connector and a first signal pin of one of the fourth connectors. The third signal pin of the first connector may be connected to another second connector through a third signal pin of the third connector and a first signal pin of another fourth connector. The second signal pin of the first connector may be connected to a second signal pin of the third connector and may be connected to the ground terminal. The second signal pin of the third connector may be connected to the one of the second connectors through a second signal pin of the one of the fourth connectors, and the second signal pin of the third connector may further be connected to another second connector through a second signal pin of the another fourth connector.

It can be learned that, the power system provided in this application may identify the types of three types of power cables, for example, a 3 kW power cable, a 4 kW power cable, and a 6 kW power cable, through the voltage source, the first voltage divider resistor, the second voltage divider resistor, the third connector, the fourth connector, the first sampling circuit, and the second sampling circuit.

In some possible implementations, when the power system is configured to identify a type of a single power cable, the power entry module may include a third connector and a fourth connector. The power module may further include a first voltage divider resistor. The power entry module may further include a third voltage divider resistor.

Optionally, the first voltage divider resistor may be connected to the voltage source. A second end of the first voltage divider resistor may be connected to the sampling circuit, the second end of the first voltage divider resistor may further be connected to a first signal pin of the third connector through the first signal pin of the first connector. The second signal pin of the first connector may be connected to a second signal pin of the third connector and may be connected to a ground terminal. The third voltage divider resistor may be connected between the first signal pin of the third connector and a third signal pin of the fourth connector. Alternatively, the third voltage divider resistor may be connected between the first signal pin of the third connector and a first signal pin of the fourth connector. The second signal pin of the third connector may be connected to a second signal pin of the fourth connector. The first signal pin, the second signal pin, and the third signal pin of the fourth connector may be separately connected to the second connector.

It can be learned that, the power system provided in this application may identify the types of three types of power cables, for example, a 3 kW power cable, a 4 kW power cable, and a 6 kW power cable, through the voltage source, the first voltage divider resistor, the third connector, the fourth connector, and the sampling circuit.

In some other possible implementations, when the power system is configured to identify types of a plurality of power cables, the power entry module may include a third connector and a plurality of fourth connectors, the power module may include a plurality of sampling circuits, the plurality of power cables may include a plurality of second connectors, and the plurality of second connectors one-to-one correspond to the plurality of fourth connectors. The power module may further include a first voltage divider resistor and a second voltage divider resistor. The power entry module may further include a third voltage divider resistor and a fourth voltage divider resistor.

Respective first ends of the first voltage divider resistor and the second voltage divider resistor may be connected to the voltage source. A second end of the first voltage divider resistor may be connected to a first sampling circuit in the plurality of sampling circuits. The second end of the first voltage divider resistor may further be connected to a first signal pin of the third connector through the first signal pin of the first connector. A second end of the second voltage divider resistor may be connected to a second sampling circuit in the plurality of sampling circuits, and the second end of the second voltage divider resistor may further be connected to a third signal pin of the third connector through the third signal pin of the first connector. The second signal pin of the first connector may be connected to a second signal pin of the third connector and may be connected to the ground terminal. The third voltage divider resistor may be connected between the first signal pin of the third connector and a third signal pin of one of the fourth connectors. Alternatively, the third voltage divider resistor may be connected between the first signal pin of the third connector and a first signal pin of one of the fourth connectors. The fourth voltage divider resistor may be connected between the third signal pin of the third connector and a third signal pin of another fourth connector. Alternatively, the fourth voltage divider resistor may be connected between the third signal pin of the third connector and a first signal pin of the another fourth connector. The second signal pin of the third connector may be connected to a second signal pin of each fourth connector. The first signal pin, a second signal pin, and the third signal pin of the one of the fourth connectors may be separately connected to one of the second connectors; and the first signal pin, a second signal pin, and the third signal pin of the another fourth connector may be connected to the another second connector.

It can be learned that, the power system provided in this application may identify the types of three types of power cables, for example, a 3 kW power cable, a 4 kW power cable, and a 6 kW power cable, through the voltage source, the first voltage divider resistor, the third connector, the fourth connector, and the sampling circuit.

In an example, the first connector may further include a first power pin. A friction distance of the first signal pin, the second signal pin, or the third signal pin may be less than a friction distance of the first power pin. The friction distance may indicate a motion distance of a contact point of the first signal pin, the second signal pin, or the third signal pin. It may be figured out that, in a process in which the first connector is plugged in the second connector, the signal pin may be connected later than the power pin. In a process in which the second connector is unplugged from the first connector, the signal pin may be disconnected before the power pin. Therefore, in plugging and unplugging processes of the first connector and the second connector, the power system determines, by detecting the signal pin, whether the power system is powered on or powered off. In a process in which the second connector is plugged in the first connector, the power system is not powered on at a moment at which the power pins are in contact with each other. In a process in which the second connector is unplugged from the first connector, the power system is also not powered on at a moment at which the power pins are separated from each other. Therefore, this can effectively avoid hot plugging of the first connector and the second connector, and can also effectively avoid arcing and erosion of the respective power pins of the first connector and the second connector at the moment at which the respective power pins are in contact with each other in a hot plugging scenario.

Optionally, when types of a first power cable and a second power cable in the plurality of power cables identified by the power system are different, the power system may be configured to output an active power based on a rated power of the first power cable. Alternatively, the power system may be configured to output an active power based on a rated power of the second power cable, and issue alarm information.

The rated power of the first power cable is less than the rated power of the second power cable. The alarm information indicates to replace the second power cable.

According to a second aspect, this application provides a network device, which may include a power cable and the power system provided in the first aspect and the possible implementations of the first aspect. The power system may be connected to the power cable, and the power cable may be connected to a power supply.

It should be understood that the technical solution in the second aspect of this application is consistent with that in the first aspect of this application, and beneficial effect achieved by the aspects and the corresponding feasible implementations is similar. Details are not described again.

### BRIEF DESCRIPTION OF DRAWINGS

To describe technical solutions in this application or in the conventional technology more clearly, the following briefly describes accompanying drawings for describing embodiments or the conventional technology. It is clearly that the accompanying drawings in the following descriptions show some embodiments of this application, and a person of ordinary skill in the art may still derive other accompanying drawings from these accompanying drawings without creative efforts.
FIG. 1 is a diagram of a structure of a power system 10 according to an embodiment of this application;
FIG. 2 is another diagram of a structure of a power system 10 according to an embodiment of this application;
FIG. 3 is a diagram of a structure in which a power system 10 is connected to a power cable L1 according to an embodiment of this application;
FIG. 4 is a diagram of a structure in which a power system 10 is connected to a power cable L1 and a power cable L2 according to an embodiment of this application;
FIG. 5a is a diagram of a structure of a first connector 1 according to an embodiment of this application;
FIG. 5b is another diagram of a structure of a first connector 1 according to an embodiment of this application;
FIG. 5c is another diagram of a structure of a first connector 1 according to an embodiment of this application;
FIG. 6a is a diagram of a structure of a second connector 2 according to an embodiment of this application;
FIG. 6b is another diagram of a structure of a second connector 2 according to an embodiment of this application;
FIG. 6c is another diagram of a structure of a second connector 2 according to an embodiment of this application;
FIG. 6d is another diagram of a structure of a second connector 2 according to an embodiment of this application;
FIG. 7a is a diagram of a structure of a friction distance c1 of a signal pin of a first connector 1 according to an embodiment of this application;
FIG. 7b is a diagram of a structure of a friction distance c2 of a power pin of a first connector 1 according to an embodiment of this application;
FIG. 8a is a diagram of a connection sequence of respective signal pins and power pins of a first connector 1 and a second connector 2 according to an embodiment of this application;
FIG. 8b is a diagram of a disconnection sequence of respective signal pins and power pins of a first connector 1 and a second connector 2 according to an embodiment of this application;
FIG. 9a is a diagram of a structure of a power system 10 according to an embodiment of this application;
FIG. 9b is another diagram of a structure of a power system 10 according to an embodiment of this application;
FIG. 10a is a diagram of a structure of a power system 10 according to an embodiment of this application;
FIG. 10b is another diagram of a structure of a power system 10 according to an embodiment of this application;
FIG. 11a is a diagram of a structure of a power system 10 according to an embodiment of this application;
FIG. 11b is another diagram of a structure of a power system 10 according to an embodiment of this application;
FIG. 12a is a diagram of a structure of a power system 10 according to an embodiment of this application;
FIG. 12b is another diagram of a structure of a power system 10 according to an embodiment of this application;
FIG. 13a is a diagram of a structure of a power system 10 according to an embodiment of this application;
FIG. 13b is another diagram of a structure of a power system 10 according to an embodiment of this application;
FIG. 14a is a diagram of a connection relationship between a power system 10 and a power cable L1 according to an embodiment of this application;
FIG. 14b is a diagram of a connection relationship between a power system 10 and each of a power cable L1 and a power cable L2 according to an embodiment of this application;
FIG. 15a is a diagram of a structure of a power system 10 according to an embodiment of this application;
FIG. 15b is another diagram of a structure of a power system 10 according to an embodiment of this application;
FIG. 16a is a diagram of a structure of a power system 10 according to an embodiment of this application;
FIG. 16b is another diagram of a structure of a power system 10 according to an embodiment of this application;
FIG. 17a is a diagram of a structure of a network device 100 according to an embodiment of this application; and
FIG. 17b is another diagram of a structure of a network device 100 according to an embodiment of this application.

### DESCRIPTION OF EMBODIMENTS

The following describes technical solutions of this application with reference to accompanying drawings.

To make objectives, technical solutions, and advantages of this application clearer, the following clearly and completely describes the technical solutions in this application with reference to the accompanying drawings in this application. It is clear that described embodiments are some rather than all of embodiments of this application. All other embodiments obtained by a person of ordinary skill in the art based on embodiments of this application without creative efforts shall fall within the protection scope of this application.

In the specification, embodiments, claims, and accompanying drawings of this application, the terms "first", "second", and the like are merely intended for distinguishing and description, and shall not be understood as indicating or implying relative importance, or indicating or implying a sequence. In addition, the terms "include", "have", and any variant thereof are intended to cover non-exclusive inclusion, for example, include a series of steps or units. For example, methods, systems, products, or devices are not necessarily limited to those steps or units expressly listed, but may include other steps or units not expressly listed or inherent to such processes, methods, products, or devices.

It should be understood that in this application, "at least one (item)" means one or more, and "a plurality of" means two or more. The term "and/or" is used for describing an association relationship between associated objects, and indicates that three relationships may exist. For example, "A and/or B" may indicate the following three cases: Only A exists, only B exists, and both A and B exist, where A and B may be singular or plural. The character "/" generally represents an "or" relationship between the associated objects. The expression "at least one of the following items (pieces)" or a similar expression means any combination of these items, including a single item (piece) or any combination of a plurality of items (pieces). For example, at least one of a, b, or c may indicate a, b, c, a and b, a and c, b and c, or a, b, and c, where a, b, and c may be singular or plural.

With rapid development of communication network technologies, network devices are widely used. The network device may include a power system and a terminal device. The power system may include a power module. The power module may be connected to a power supply through a power cable, and the power module may further be connected to the terminal device through a cable. The network device has a long service life. When the power module is upgraded within the service life of the network device, the power cable needs to be upgraded synchronously. To ensure compatibility of a power cable socket and avoid incorrect plug-in of the power cable, the power system needs to have a function of identifying a type of the power cable. In a related technology, an electronic chip and an active component are usually disposed in the power cable. The electronic chip may control the active component to send, to the terminal device, identification information indicating the type of the power cable (for example, a 3 kW power cable, a 4 kW power cable, or a 6 kW power cable), so as to identify the type of the power cable. However, disposing the electronic chip and the active component may increase costs of the power cable. In addition, because the network device needs to run reliably for a long time, and the active component is easy to be damaged, reliability of the power cable is greatly reduced, and operation and maintenance costs of the network device are increased.

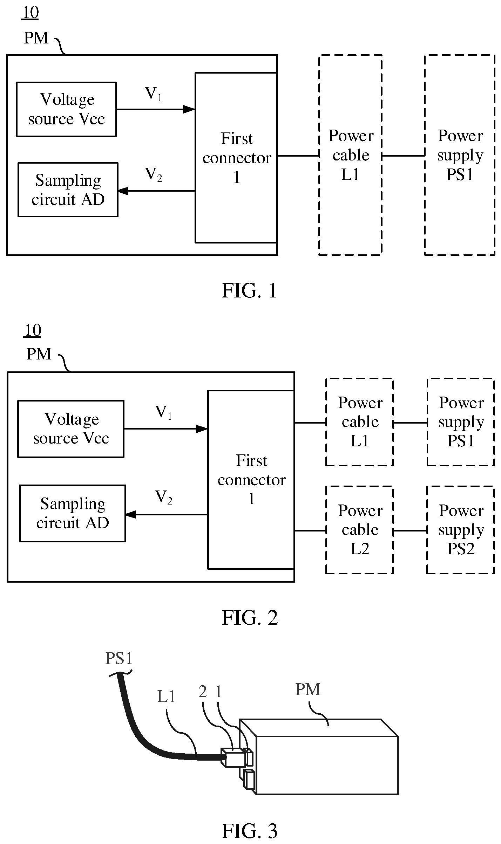

To overcome the foregoing disadvantages, an embodiment of this application provides a power system, as shown in FIG. 1 and FIG. 2. The power system 10 may include a power module (power module, PM). The PM may include a voltage source V_{CC}, a sampling circuit AD, and a first connector 1.

The first connector 1 may be configured to connect to a power cable L1, and the power cable L1 may be connected to a power supply PS1, as shown in FIG. 1. In FIG. 1, the power system 10 may have a single power entry scenario, and the power system 10 is configured to identify a type of a single power cable (that is, the power cable L1). For the single power entry scenario of the power system 10, refer to FIG. 3.

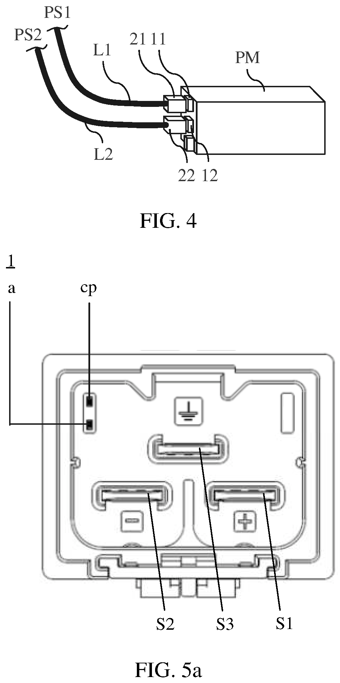

Certainly, the first connector 1 may be configured to connect to a power cable L1 and a power cable L2, the power cable L1 may be connected to a power supply PS1, and the power cable L2 may be connected to a power supply PS2, as shown in FIG. 2. In FIG. 2, the power system 10 may have a dual power entry scenario (that is, a multi-power entry scenario). The power system 10 is configured to identify types of two power cables (that is, the power cable L1 and the power cable L2). For the dual power entry scenario of the power system 10, refer to FIG. 4.

Optionally, the voltage source V_{CC} may be configured to provide a first detection voltage V₁ for the first connector 1.

The sampling circuit may be configured to: acquire a second detection voltage V₂ from the first connector 1, and identify a type of the power cable L1 (or the types of the power cable L1 and the power cable L2) based on the second detection voltage V2. The type of the power cable L1 or the power cable L2 may include a type-A power cable, a type-B power cable, and a type-C power cable. The type-A power cable may be a 4 kW power cable, the type-B power cable may be a 6 kW power cable, and the type-C power cable may be a 3 kW power cable or the like. This is not limited in this embodiment of this application.

According to the power system 10 provided in this embodiment of this application, the second detection voltage V₂ of the first connector 1 may be acquired based on the first detection voltage V₁ provided by the voltage source V_{CC}, so that the type of the power cable is identified based on the second detection voltage V₂. It can be learned that, in comparison with the related technology in which an electronic chip and an active component are disposed in a power cable, the power system 10 provided in this embodiment of this application implements identification of a type of a power cable, ensures reliability of the power cable, and avoids an increase in operation and maintenance costs of a network device.

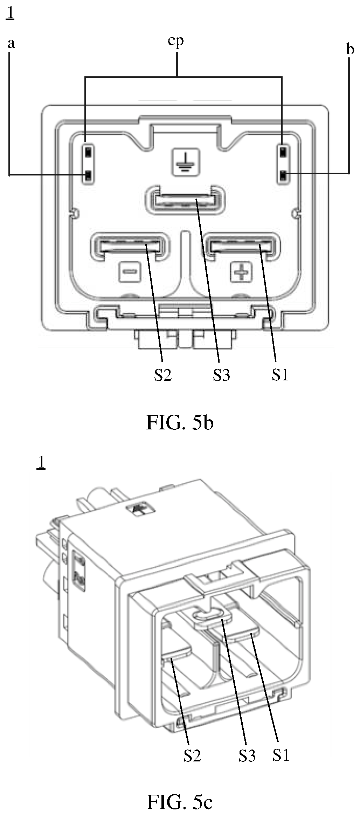

Further, as shown in FIG. 5a, the first connector 1 may include a first signal pin a and a second signal pin cp. Alternatively, as shown in FIG. 5b, the first connector 1 may include a first signal pin a, a third signal pin b, and a second signal pin cp.

Optionally, the first connector 1 may further include a plurality of first power pins (including a positive power pin S1, a negative power pin S2, and a ground power pin S3), as shown in FIG. 5c. Lengths of the positive power pin S1, the negative power pin S2, and the ground power pin S3 may be equal. Friction distances of the positive power pin S1, the negative power pin S2, and the ground power pin S3 may be equal. The friction distance may indicate a motion distance of a contact point of the first power pin.

In some embodiments, for the single power entry scenario of the power system 10, refer to FIG. 3. The power cable L1 may include the second connector 2, and the second connector 2 may be configured to connect to the first connector 1.

The second connector 2 may be configured to short-circuit the second signal pin cp and the first signal pin a of the first connector 1.

It can be learned that the power system 10 provided in this embodiment of this application may identify the type of the power cable L1 through the first connector 1.

For the dual power entry scenario of the power system 10, refer to FIG. 4. The power cable L1 may include a second connector 21, and the second connector 21 may be configured to connect to a first connector 11. Similarly, the power cable L2 may include a second connector 22, and the second connector 22 may be configured to connect to a first connector 12.

The second connector 21 may be configured to short-circuit a first signal pin a and a second signal pin cp of the first connector 11, or short-circuit a third signal pin b and a second signal pin cp of the first connector 11.

Similarly, the second connector 22 may be configured to short-circuit a first signal pin a and a second signal pin cp of the second connector 12, or short-circuit a third signal pin b and a second signal pin cp of the second connector 12.

It can be learned that the power system 10 provided in this embodiment of this application may identify the types of the power cable L1 and the power cable L2 through the first connector 11 and the first connector 12.

The following describes the second connector by using the second connector 2 as an example.

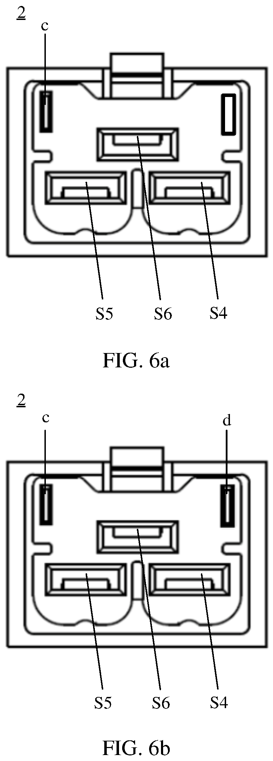

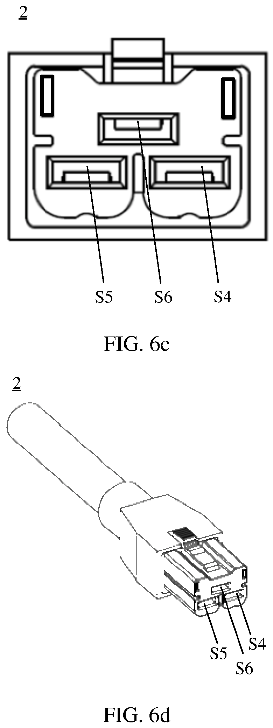

Optionally, the second connector 2 may include a short-circuit pin c, as shown in FIG. 6a. In addition to the short-circuit pin c, the second connector 2 may further include an open-circuit pin d, as shown in FIG. 6b. Alternatively, the second connector 2 may not be provided with a short-circuit pin c or an open-circuit pin d, as shown in FIG. 6c.

Similar to the first connector 1, the second connector 2 may also include a plurality of second power pins (including a positive power pin S4, a negative power pin S5, and a ground power pin S6), as shown in FIG. 6a to FIG. 6d.

In an example, for the second connector 2 shown in FIG. 6a, lengths of the short-circuit pin c and the plurality of second power pins may be equal, and friction distances of the short-circuit pin c and the plurality of power pins may be equal.

In another example, for the second connector 2 shown in FIG. 6b, lengths of the short-circuit pin c, the open-circuit pin d, and the plurality of second power pins may be equal, and friction distances of the short-circuit pin c, the open-circuit pin d, and the plurality of second power pins may be equal.

In still another example, for the second connector 2 shown in FIG. 6c, lengths of the plurality of power pins may be equal, and friction distances of the plurality of power pins may be equal.

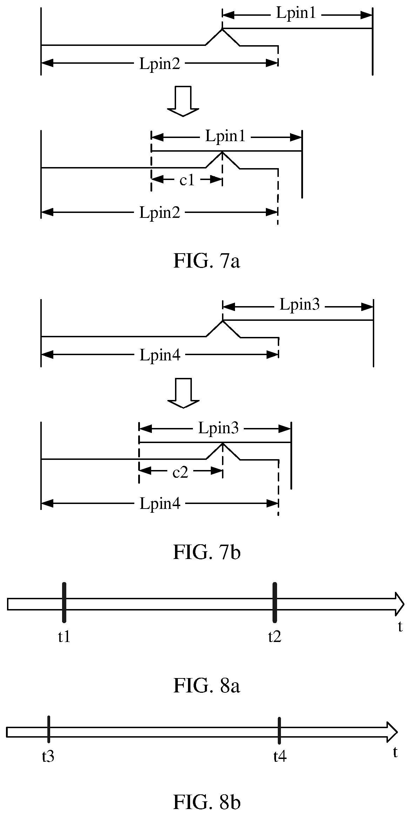

Optionally, as shown in FIG. 7a, Lpin1 represents a length of a signal pin (including the first signal pin a, the second signal pin cp, or the third signal pin b) of the first connector 1, Lpin2 represents a length of the short-circuit pin c of the second connector 2, and c1 represents a friction distance of the signal pin of the first connector 1.

As shown in FIG. 7b, Lpin3 represents a length of a first power pin (including the positive power pin S1, the negative power pin S2, or the ground power pin S3), and Lpin4 represents a length of a second power pin (including the positive power pin S4, the negative power pin S5, or the ground power pin S6). c2 represents a friction distance of the first power pin.

It can be learned from FIG. 7a and FIG. 7b that c1<c2. In other words, the friction distance c1 of the signal pin of the first connector 1 may be less than the friction distance c2 of the first power pin.

Therefore, in a process in which the first connector 1 is plugged in the second connector 2, a connection sequence of the respective signal pins and power pins of the first connector 1 and the second connector 2 is shown in FIG. 8a. In FIG. 8a, t represents time, t1 represents a connection moment of the first power pin and the second power pin, and t2 represents a connection moment of the respective signal pins of the first connector 1 and the second connector 2. It can be learned from FIG. 8a that, the respective signal pins of the first connector 1 and the second connector 2 may be connected later than the respective power pins of the first connector 1 and the second connector 2. In this way, in the process in which the first connector 1 is plugged in the second connector 2, the power system 10 determines, by detecting the signal pin, whether the power system 10 is powered on.

In a process in which the second connector 2 is unplugged from the first connector 1, a disconnection sequence of the respective signal pins and respective the power pins of the first connector 1 and the second connector 2 is shown in FIG. 8b. In FIG. 8b, t represents time, t3 represents a disconnection moment of the respective signal pins of the first connector 1 and the second connector 2, and t4 represents a disconnection moment of the first power pin and the second power pin. It can be learned from FIG. 8b that the respective signal pins of the first connector 1 and the second connector 2 may be disconnected before the respective power pins of the first connector 1 and the second connector 2. In this way, in the process in which the second connector 2 is unplugged from the first connector 1, the power system 10 determines, by detecting the signal pin, whether the power system 10 is powered off.

It may be figured out that, in plugging and unplugging processes of the first connector 1 and the second connector 2, the power system 10 is not powered on at a moment at which the first power pin is in contact with the second power pin and at a moment at which the first power pin is separated from the second power pin. This can effectively avoid hot plugging of the first connector 1 and the second connector 2, and can also effectively avoid arcing and erosion of the first power pin and the second power pin at the moment at which the first power pin is in contact with the second power pin in a hot plugging scenario.

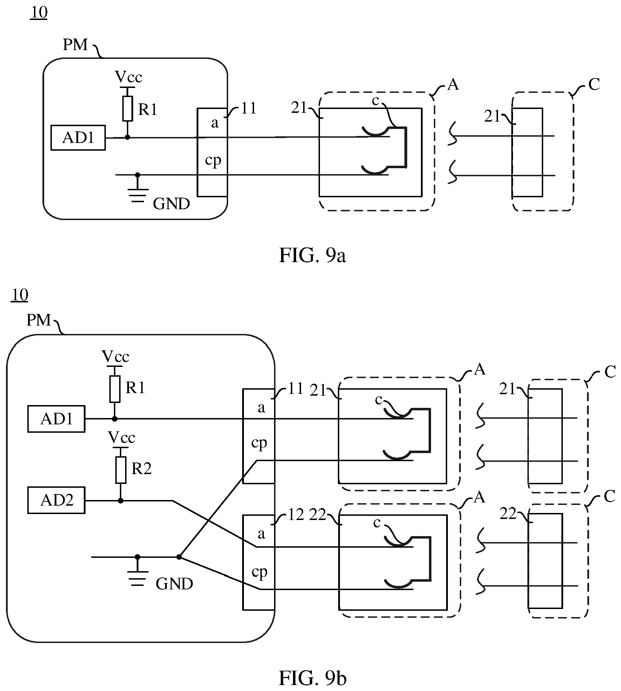

In some embodiments, for the single power entry scenario, the PM may further include a first voltage divider resistor R1, as shown in FIG. 9a.

Optionally, a first end of the first voltage divider resistor R1 is connected to the voltage source Vcc. A second end of the first voltage divider resistor R1 may be connected to a first sampling circuit AD1. The second end of the first voltage divider resistor R1 may further be connected to the second connector 21 through the first signal pin a of the first connector 11. The second signal pin cp of the first connector 11 may be connected to the second connector 21 and may be connected to a ground terminal. For the type-A power cable, a short-circuit pin c of the second connector 21 may short-circuit the second signal pin cp and the first signal pin a of the first connector 11. It can be learned that, the power system 10 provided in this embodiment of this application may identify the types of two types of power cables, for example, a type-A power cable (4 kW power cable) and a type-C power cable (3 kW power cable), through the voltage source Vcc, the first voltage divider resistor R1, and the first sampling circuit AD1.

In some other embodiments, for the dual power entry scenario, the PM may include a plurality of first connectors (the first connector 11 and the second connector 12) and a plurality of sampling circuits (a first sampling circuit AD1 and a second sampling circuit AD2). The plurality of power cables include a plurality of second connectors (the second connector 21 and the second connector 22). The PM may further include a first voltage divider resistor R1 and a second voltage divider resistor R2, as shown in FIG. 9b.

Respective first ends of the first voltage divider resistor R1 and the second voltage divider resistor R2 may be connected to the voltage source Vcc. A second end of the first voltage divider resistor R1 may be connected to the first sampling circuit AD1, and the second end of the first voltage divider resistor R1 may further be connected to the second connector 21 through the first signal pin a of the first connector 11. A second end of the second voltage divider resistor R2 may be connected to the second sampling circuit AD2, and the second end of the second voltage divider resistor R2 may further be connected to the second connector 22 through a first signal pin a of the first connector 12. The second signal pin cp of the first connector 11 may be connected to the second connector 21, and a second signal pin cp of the first connector 12 may be connected to the second connector 22. The respective second signal pins cp of the first connector 11 and the first connector 12 may be connected to the ground terminal. For the type-A power cable, a short-circuit pin c of the second connector 21 may short-circuit the second signal pin cp and the first signal pin a of the first connector 11. A short-circuit pin c of the second connector 22 may also short-circuit the second signal pin cp and the first signal pin a of the first connector 12. It can be learned that, the power system 10 provided in this embodiment of this application may identify the types of two types of power cables, for example, a type-A power cable (4 kW power cable) and a type-C power cable (3 kW power cable), through the voltage source Vcc, the first voltage divider resistor R1, the second voltage divider resistor R2, the first sampling circuit AD1, and the second sampling circuit AD2.

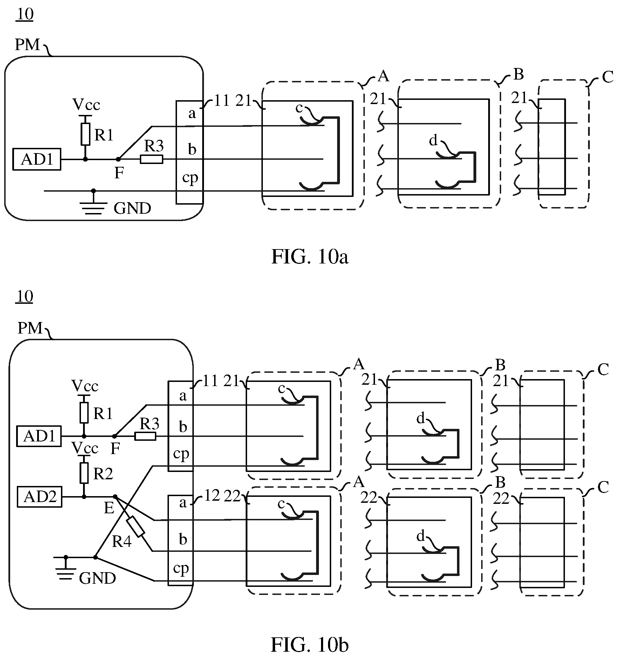

Further, based on FIG. 9a, the PM may further include a third voltage divider resistor R3, as shown in FIG. 10a. A first end of the third voltage divider resistor R3 may be connected to the first sampling circuit AD1. The first end of the third voltage divider resistor R3 may be connected to the second connector 21 through the first signal pin a of the first connector 11. A second end of the third voltage divider resistor R3 may be connected to the second connector 21 through the third signal pin b of the first connector 11. In other words, the third voltage divider resistor R3 may be connected between a node F and the third signal pin b of the first connector 11, as shown in FIG. 10a.

Alternatively, the first end of the third voltage divider resistor R3 may be connected to the second connector 21 through the third signal pin b of the first connector 11. A second end of the third voltage divider resistor R3 may be connected to the second connector 21 through the first signal pin a of the first connector 11. In other words, the third voltage divider resistor R3 may alternatively be connected between a node F and the first signal pin a of the first connector 11.

It can be learned that, the power system 10 provided in this embodiment of this application may identify the types of three types of power cables, for example, a type-A power cable (4 kW power cable), a type-B power cable (6 kW power cable), and a type-C power cable (3 kW power cable), through the voltage source Vcc, the first voltage divider resistor R1, the third voltage divider resistor R3, and the first sampling circuit AD1.

Based on FIG. 9b, the PM may further include a third voltage divider resistor R3 and a fourth voltage divider resistor R4, as shown in FIG. 10b. A first end of the third voltage divider resistor R3 may be connected to the first sampling circuit AD1. The first end of the third voltage divider resistor R3 may further be connected to the second connector 21 through the first signal pin a of the first connector 11. A second end of the third voltage divider resistor R3 may be connected to the second connector 21 through the third signal pin b of the first connector 11. In other words, the third voltage divider resistor R3 may be connected between a node F and the third signal pin b of the first connector 11, as shown in FIG. 10b. Alternatively, the first end of the third voltage divider resistor R3 may further be connected to the second connector 21 through the third signal pin b of the first connector 11. A second end of the third voltage divider resistor R3 may be connected to the second connector 21 through the first signal pin a of the first connector 11. In other words, the third voltage divider resistor R3 may alternatively be connected between a node F and the first signal pin a of the first connector 11.

A first end of the fourth voltage divider resistor R4 may be connected to the second sampling circuit AD2. The first end of the fourth voltage divider resistor R4 may further be connected to the second connector 22 through the first signal pin a of the first connector 12. A second end of the fourth voltage divider resistor R4 may be connected to the second connector 22 through the third signal pin b of the first connector 12. In other words, the third voltage divider resistor R4 may be connected between a node E and the third signal pin b of the first connector 12, as shown in FIG. 10b. Alternatively, the first end of the fourth voltage divider resistor R4 may further be connected to the second connector 22 through the third signal pin b of the first connector 12. A second end of the fourth voltage divider resistor R4 may be connected to the second connector 22 through the first signal pin a of the first connector 12. In other words, the fourth voltage divider resistor R4 may alternatively be connected between a node E and the first signal pin a of the first connector 12.

It can be learned that, the power system provided in this embodiment of this application may identify the types of three types of power cables, for example, a type-A power cable (4 kW power cable), a type-B power cable (6 kW power cable), and a type-C power cable (3 kW power cable), through the voltage source Vcc, the first voltage divider resistor R1, the second voltage divider resistor R2, the third voltage divider resistor R3, the fourth voltage divider resistor R4, the first sampling circuit AD1, and the second sampling circuit AD2.

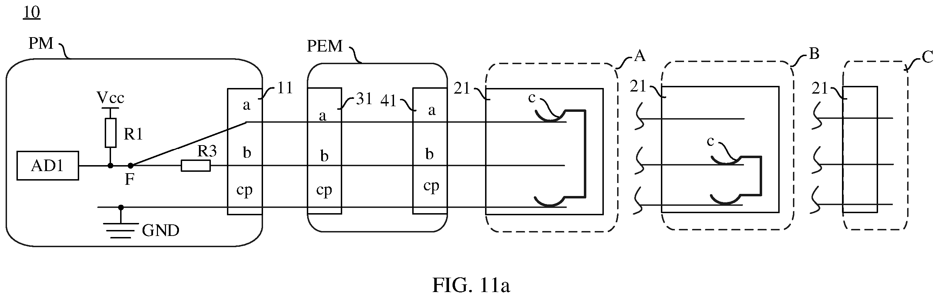

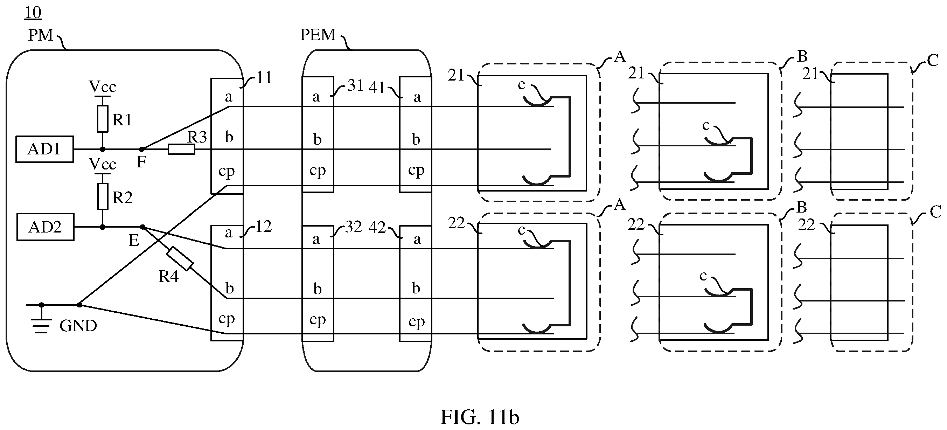

Further, based on FIG. 10a, the power system 10 may further include a power entry module (power entry module, PEM), as shown in FIG. 11a and FIG. 11b.

Optionally, as shown in FIG. 11a, the PEM includes a third connector 31 and a fourth connector 41. The third connector 31 may be configured to connect to the first connector 11, and the fourth connector 41 may be configured to connect to the second connector 21.

As shown in FIG. 11b, the PEM includes a third connector 31, a third connector 32, a fourth connector 41, and a fourth connector 42. The third connector 31 may be configured to connect to the first connector 11, and the fourth connector 41 may be configured to connect to the second connector 21. Similarly, the third connector 32 may be configured to connect to the first connector 12, and the fourth connector 42 may be configured to connect to the second connector 22.

The power system 10 provided in FIG. 11a and FIG. 11b in embodiments of this application may identify the types of three types of power cables, for example, a type-A power cable (4 kW power cable), a type-B power cable (6 kW power cable), and a type-C power cable (3 kW power cable), through the PM and the PEM.

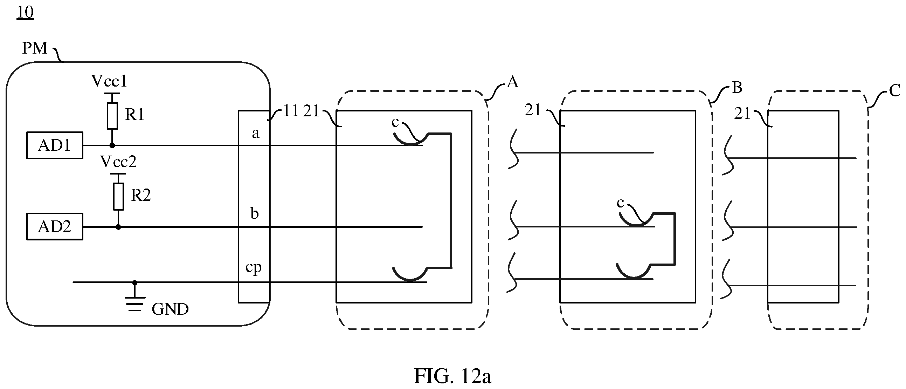

In a possible implementation, for the single power entry scenario, the PM may include a plurality of sampling circuits (the first sampling circuit AD1 and the second sampling circuit AD2). The PM may further include the first voltage divider resistor R1 and the second voltage divider resistor R2, as shown in FIG. 12a. A first end of the first voltage divider resistor R1 may be connected to a voltage source Vcc1. A second end of the first voltage divider resistor R1 is connected to the first sampling circuit AD1, and the second end of the first voltage divider resistor R1 is further connected to the second connector 21 through the first signal pin a of the first connector 11. A first end of the second voltage divider resistor R2 may be connected to a voltage source Vcc2. A second end of the second voltage divider resistor R2 is connected to the second sampling circuit AD2, and the second end of the second voltage divider resistor R2 is further connected to the second connector 21 through the third signal pin b of the first connector 11. The second signal pin cp of the first connector 11 is connected to the second connector 21 and is connected to the ground terminal. For the type-A power cable, the short-circuit pin c of the second connector 21 may short-circuit the second signal pin cp and the first signal pin a of the first connector 11. For the type-B power cable, the short-circuit pin c of the second connector 21 may short-circuit the second signal pin cp and the third signal pin b of the first connector 11. It can be learned that, the power system 10 provided in this embodiment of this application may identify the types of three types of power cables, for example, a type-A power cable (4 kW power cable), a type-B power cable (6 kW power cable), and a type-C power cable (3 kW power cable), through the voltage source Vcc1, the voltage source Vcc2, the first sampling circuit AD1, the second sampling circuit AD2, the first voltage divider resistor R1, and the second voltage divider resistor R2.

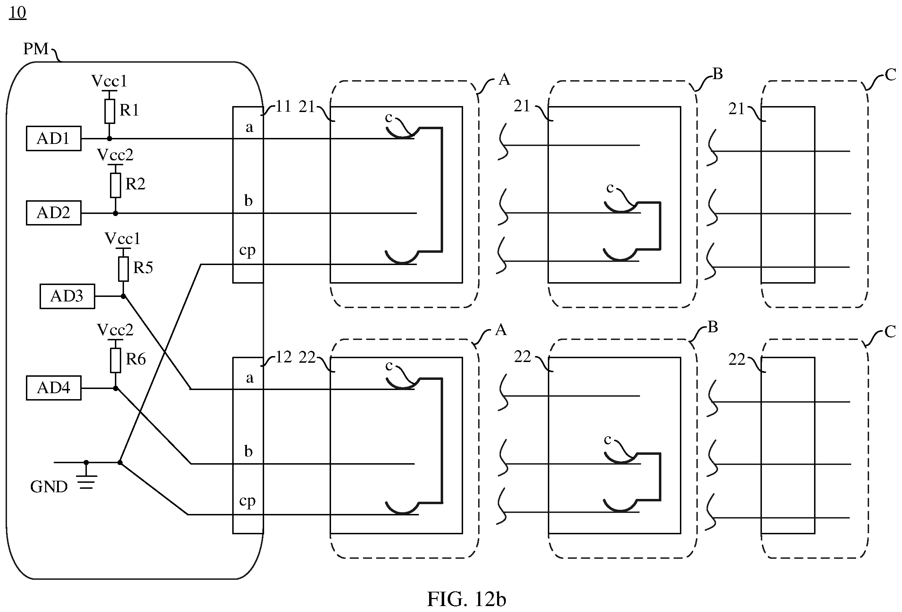

In another possible implementation, for the dual power entry scenario, the PM may include a plurality of first connectors (the first connector 11 and the first connector 12) and a plurality of sampling circuits (the first sampling circuit AD1, the second sampling circuit AD2, a third sampling circuit AD3, and a fourth sampling circuit AD4). The plurality of power cables include a plurality of second connectors (the second connector 21 and the second connector 22). The PM further includes the first voltage divider resistor R1, the second voltage divider resistor R2, a fifth voltage divider resistor R5, and a sixth voltage divider resistor R6, as shown in FIG. 12b.

Respective first ends of the first voltage divider resistor R1 and the fifth voltage divider resistor R5 may be connected to the voltage source Vcc1, and respective first ends of the second voltage divider resistor R2 and the sixth voltage divider resistor F6 may be connected to the voltage source Vcc2. A second end of the first voltage divider resistor R1 is connected to the first sampling circuit AD1, and the second end of the first voltage divider resistor R1 is further connected to the second connector 21 through the first signal pin a of the first connector 11. A second end of the second voltage divider resistor R2 is connected to the second sampling circuit AD2, and the second end of the second voltage divider resistor R2 is further connected to the second connector 21 through the third signal pin b of the first connector 11. The second signal pin cp of the first connector 11 is connected to the second connector 21 and is connected to the ground terminal.

A second end of the fifth voltage divider resistor R5 is connected to the third sampling circuit AD3, and the second end of the fifth voltage divider resistor R5 is further connected to the second connector 22 through the first signal pin a of the first connector 12. A second end of the sixth voltage divider resistor R6 may be connected to the fourth sampling circuit AD4, and the second end of the sixth voltage divider resistor R6 is further connected to the second connector 22 through the third signal pin b of the first connector 12. The second signal pin cp of the first connector 12 is connected to the second connector 22 and is connected to the ground terminal. For the type-A power cable, the short-circuit pin c of the second connector 21 may short-circuit the second signal pin cp and the first signal pin a of the first connector 11. The short-circuit pin c of the second connector 22 may short-circuit the second signal pin cp and the first signal pin a of the first connector 12. For the type-B power cable, the short-circuit pin c of the second connector 21 may short-circuit the second signal pin cp and the third signal pin b of the first connector 11. The short-circuit pin c of the second connector 22 may short-circuit the second signal pin cp and the third signal pin b of the first connector 12.

It can be learned that, the power system 10 provided in this embodiment of this application may identify the types of three types of power cables, for example, a type-A power cable (4 kW power cable), a type-B power cable (6 kW power cable), and a type-C power cable (3 kW power cable), through the voltage source Vcc1, the voltage source Vcc2, the first voltage divider resistor R1, the second voltage divider resistor R2, the third voltage divider resistor R3, the fourth voltage divider resistor R4, the first sampling circuit AD1, the second sampling circuit AD2, the third sampling circuit AD3, and the fourth sampling circuit AD4.

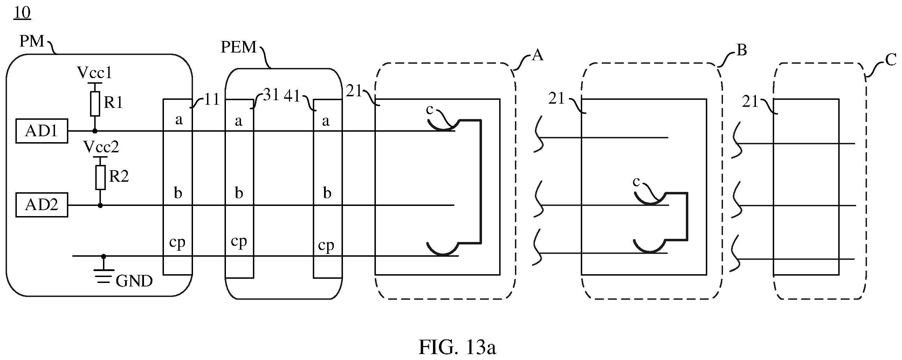

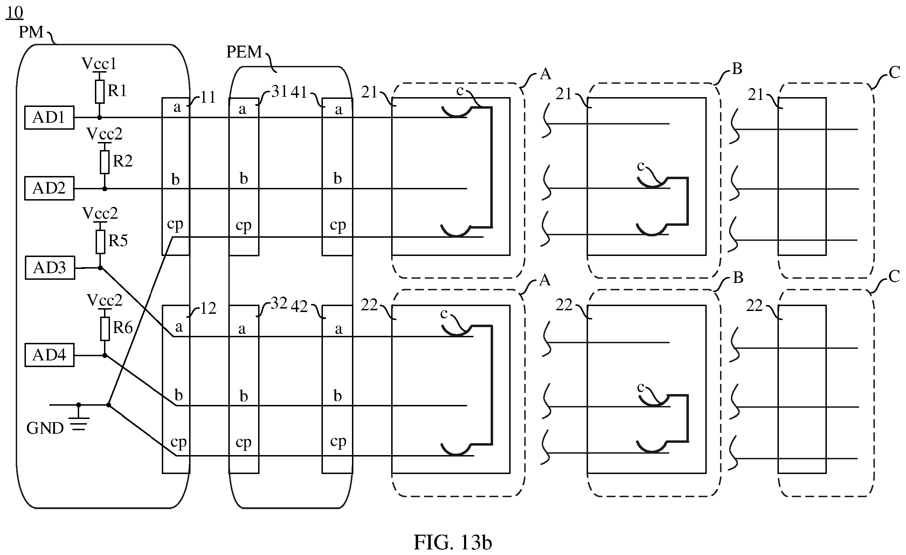

Further, based on FIG. 12a, the power system 10 may further include a power entry module (power entry module, PEM), as shown in FIG. 13a and FIG. 13b.

Optionally, as shown in FIG. 13a, the PEM includes a third connector 31 and a fourth connector 41. The third connector 31 may be configured to connect to the first connector 11, and the fourth connector 41 may be configured to connect to the second connector 21.

As shown in FIG. 13b, the PEM includes a third connector 31, a third connector 32, a fourth connector 41, and a fourth connector 42. The third connector 31 may be configured to connect to the first connector 11, and the fourth connector 41 may be configured to connect to the second connector 21. Similarly, the third connector 32 may be configured to connect to the first connector 12, and the fourth connector 42 may be configured to connect to the second connector 22.

The power system 10 provided in FIG. 13a and FIG. 13b in embodiments of this application may identify the types of three types of power cables, for example, a type-A power cable (4 kW power cable), a type-B power cable (6 kW power cable), and a type-C power cable (3 kW power cable), through the PM and the PEM.

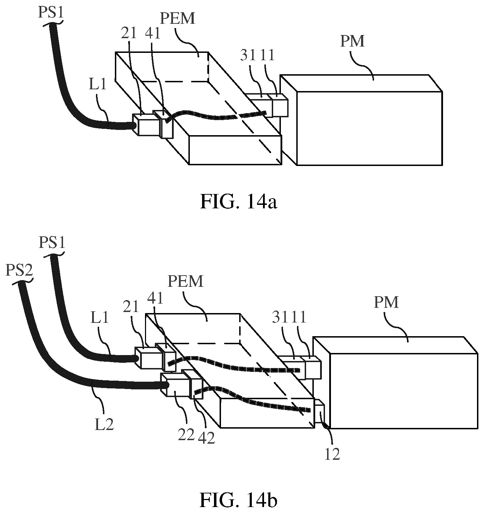

A connection relationship between the power system 10 and each of the power cable L1 shown in FIG. 11a and FIG. 13a may also be shown in FIG. 14a. In FIG. 14a, the PM is connected to the third connector 31 of the PEM through the first connector 11, and the fourth connector 41 of the PEM may be connected to the second connector 21 of the power cable L1. The power cable L1 may be connected to the power supply PS1.

A connection relationship between the power system 10 and each of the power cable L1 and the power cable L2 shown in FIG. 11b and FIG. 13b may also be shown in FIG. 14b. In FIG. 14b, the PM is connected to the third connector 31 of the PEM through the first connector 11, and the fourth connector 41 of the PEM may be connected to the second connector 21 of the power cable L1. The power cable L1 may be connected to the power supply PS1. In addition, the PM is connected to the third connector 32 of the PEM (not shown in FIG. 14b due to blocking) through the first connector 12, and the fourth connector 42 of the PEM may be connected to the second connector 22 of the power cable L2. The power cable L2 may be connected to the power supply PS2.

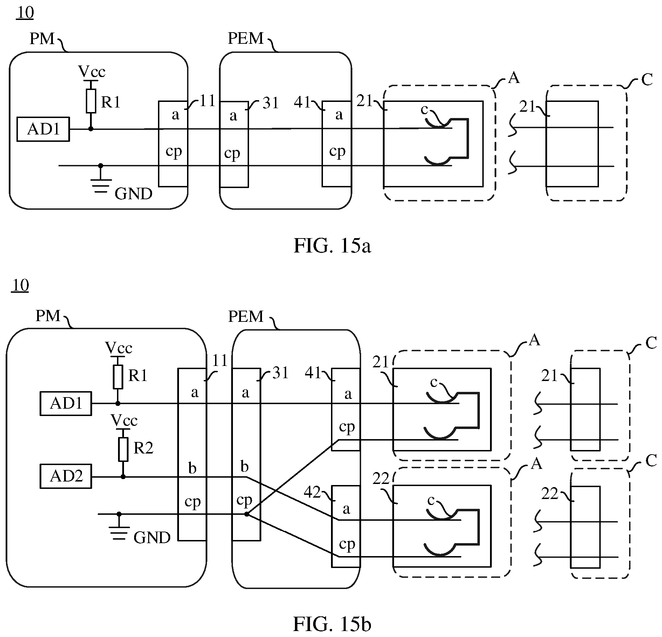

In an example, for the single power entry scenario, the PEM may include the third connector 31 and the fourth connector 41. The PM may further include the first voltage divider resistor R1, as shown in FIG. 15a.

Optionally, a first end of the first voltage divider resistor R1 may be connected to the voltage source Vcc. A second end of the first voltage divider resistor R1 may be connected to the first sampling circuit AD1. The second end of the first voltage divider resistor R1 may further be connected to the first signal pin a of the first connector 11. The first signal pin a of the first connector 11 may be connected to the second connector 21 through a first signal pin a of the third connector 31 and a first signal pin a of the fourth connector 41. Respective second signal pins cp of the first connector 11, the third connector 31, the fourth connector 41, and the second connector 21 may be connected to the ground terminal. The second signal pin cp of the first connector 11 may be connected to the second connector 21 through a second signal pin cp of the third connector 31 and a second signal pin cp of the fourth connector 41, and the second signal pin cp of the first connector 11 may be connected to the ground terminal. For the type-A power cable, the short-circuit pin c of the second connector 21 may short-circuit the second signal pin cp and the first signal pin a of the first connector 11. It can be learned that, the power system 10 provided in this embodiment of this application may identify the types of two types of power cables, for example, a type-A power cable (4 kW power cable) and a type-C power cable (3 kW power cable), through the voltage source Vcc, the first voltage divider resistor R1, the third connector 31, the fourth connector 41, and the sampling circuit.

In another example, for the dual power entry scenario, the PEM may include the third connector 31 and a plurality of fourth connectors (that is, the fourth connector 41 and the fourth connector 42), the PM may include a plurality of sampling circuits (that is, the first sampling circuit AD1 and the second sampling circuit AD2), and a plurality of power cables may include a plurality of second connectors (that is, the second connector 21 and the second connector 22). The PM may further include the first voltage divider resistor R1 and the second voltage divider resistor R2, as shown in FIG. 15b.

Respective first ends of the first voltage divider resistor R1 and the second voltage divider resistor R2 may be connected to the voltage source Vcc. A second end of the first voltage divider resistor R1 may be connected to the first sampling circuit AD1, and the second end of the first voltage divider resistor R1 may further be connected to the first signal pin a of the first connector 11. A second end of the second voltage divider resistor R2 may be connected to the second sampling circuit AD2, and the second end of the second voltage divider resistor R2 may further be connected to the third signal pin b of the first connector 11. The first signal pin a of the first connector 11 may be connected to the second connector 21 through a first signal pin a of the third connector 31 and a first signal pin a of the fourth connector 41. The third signal pin b of the first connector 11 may be connected to the second connector 22 through a third signal pin b of the third connector 31 and the first signal pin a of the fourth connector 42. The second signal pin cp of the first connector 11 is connected to a second signal pin cp of the third connector 31 and is connected to the ground terminal. The second signal pin cp of the third connector 31 is connected to the second connector 21 through a second signal pin cp of the fourth connector 42, and the second signal pin cp of the third connector 31 is further connected to the second connector 22 through the second signal pin cp of the fourth connector 42. For the type-A power cable, the short-circuit pin c of the second connector 21 may short-circuit the second signal pin cp and the first signal pin a of the first connector 11. The short-circuit pin c of the second connector 22 may short-circuit the second signal pin cp and the first signal pin a of the first connector 12. It can be learned that, the power system provided in this embodiment of this application may identify the types of two types of power cables, for example, a type-A power cable (4 kW power cable) and a type-C power cable (3 kW power cable), through the voltage source Vcc, the first voltage divider resistor R1, the second voltage divider resistor R2, the third connector 31, the fourth connector 41, the fourth connector 42, the first sampling circuit AD1, and the second sampling circuit AD2.

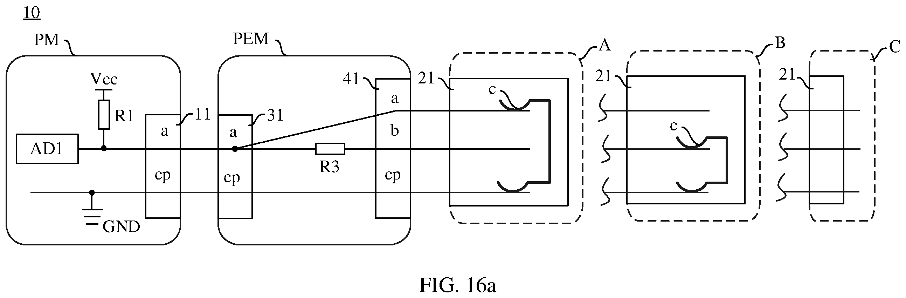

In some embodiments, for the single power entry scenario, the PEM may include the third connector 31 and the fourth connector 41. The PM may further include the first voltage divider resistor R1. The PEM may further include the third voltage divider resistor R3, as shown in FIG. 16a.

Optionally, the first voltage divider resistor R1 may be connected to the voltage source Vcc. A second end of the first voltage divider resistor R1 may be connected to the first sampling circuit AD1, and the second end of the first voltage divider resistor R1 may further be connected to the first signal pin a of the third connector 31 through the first signal pin a of the first connector 11. The second signal pin cp of the first connector 11 may be connected to the second signal pin cp of the third connector 31 and may be connected to the ground terminal. The third voltage divider resistor R3 may be connected between the first signal pin a of the third connector 31 and a third signal pin b of the fourth connector 41, as shown in FIG. 16a. The second signal pin cp of the third connector 31 may be connected to the second signal pin cp of the fourth connector 41. The first signal pin a, the second signal pin cp, and the third signal pin b of the fourth connector 41 may be separately connected to the second connector 21. For the type-A power cable, the short-circuit pin c of the second connector 21 may short-circuit the second signal pin cp and the first signal pin a of the first connector 11. For the type-B power cable, the short-circuit pin c of the second connector 21 may short-circuit the second signal pin cp and the third signal pin b of the first connector 11.

Certainly, the third voltage divider resistor R3 may alternatively be connected between the first signal pin a of the third connector 31 and the first signal pin a of the fourth connector 41. This is not limited in this embodiment of this application.

It can be learned that, the power system 10 provided in this embodiment of this application may identify the types of three types of power cables, for example, a type-A power cable (4 kW power cable), a type-B power cable (6 kW power cable), and a type-C power cable (3 kW power cable), through the voltage source Vcc, the first voltage divider resistor R1, the third connector 31, the fourth connector 41, and the first sampling circuit AD1.

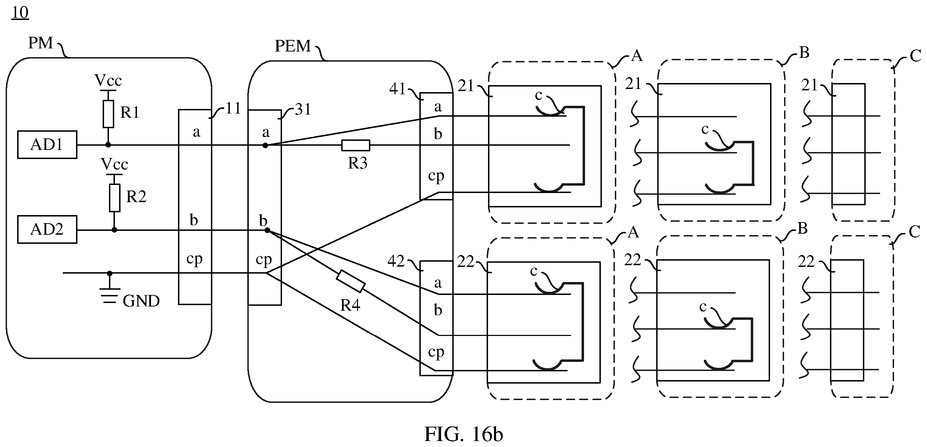

In some other embodiments, for the dual power entry scenario, the PEM may include the third connector 31 and a plurality of fourth connectors (that is, the fourth connector 41 and the fourth connector 42), the PM may include a plurality of sampling circuits (that is, the first sampling circuit AD1 and the second sampling circuit AD2), and a plurality of power cables may include a plurality of second connectors (that is, the second connector 21 and the second connector 22). The second connector 21 and the second connector 22 one-to-one correspond to the fourth connector 41 and the fourth connector 42. The PM may further include the first voltage divider resistor R1 and the second voltage divider resistor R2. The PEM may further include the third voltage divider resistor R3 and the fourth voltage divider resistor R4, as shown in FIG. 16b.

Respective first ends of the first voltage divider resistor R1 and the second voltage divider resistor R2 may be connected to the voltage source Vcc. A second end of the first voltage divider resistor R1 may be connected to the first sampling circuit AD1. The second end of the first voltage divider resistor R1 may further be connected to the first signal pin a of the third connector 31 through the first signal pin a of the first connector 11. A second end of the second voltage divider resistor R2 may be connected to the second sampling circuit AD2, and the second end of the second voltage divider resistor R2 may further be connected to a third signal pin b of the third connector 31 through the third signal pin b of the first connector 11. The second signal pin cp of the first connector 11 may be connected to the second signal pin cp of the third connector 31 and may be connected to the ground terminal. The third voltage divider resistor R3 may be connected between the first signal pin a of the third connector 31 and a third signal pin b of the fourth connector 41, as shown in FIG. 16b. The fourth voltage divider resistor R4 may be connected between the third signal pin b of the third connector 31 and the third signal pin b of the fourth connector 42. The second signal pin cp of the third connector 31 may be connected to respective second signal pins cp of the fourth connector 41 and the fourth connector 42. The first signal pin a, the second signal pin cp, and the third signal pin b of the fourth connector 41 may be connected to the second connector 21, and the first signal pin a, the second signal pin cp, and the third signal pin b of the fourth connector 42 may be connected to the second connector 22. For the type-A power cable, the short-circuit pin c of the second connector 21 may short-circuit the second signal pin cp and the first signal pin a of the first connector 11. The short-circuit pin c of the second connector 22 may short-circuit the second signal pin cp and the first signal pin a of the first connector 12. For the type-B power cable, the short-circuit pin c of the second connector 21 may short-circuit the second signal pin cp and the third signal pin b of the first connector 11. The short-circuit pin c of the second connector 22 may short-circuit the second signal pin cp and the third signal pin b of the first connector 12.

Certainly, the third voltage divider resistor R3 may alternatively be connected between the first signal pin a of the third connector 31 and the first signal pin a of the fourth connector 41. Similarly, the fourth voltage divider resistor R4 may be connected between the third signal pin b of the third connector 31 and the first signal pin a of the fourth connector 42. This is not limited in this embodiment of this application.

It can be learned that, the power system 10 provided in this embodiment of this application may identify the types of three types of power cables, for example, a type-A power cable (4 kW power cable), a type-B power cable (6 kW power cable), and a type-C power cable (3 kW power cable), through the voltage source Vcc, the first voltage divider resistor R1, the third connector 31, the fourth connector 41, the fourth connector 42, the first sampling circuit AD1, and the second sampling circuit AD2.

Further, for FIG. 16a, the PM may identify a type of a power cable in the single power entry scenario and output an active power (which may be represented by P), thereby avoiding power cable overload. For a PM with a rated power of 4 kW and a PM with a rated power of 6 kW, when the power system 10 is connected to different types of power cables, a second detection voltage acquired by the first sampling circuit AD1 from the first connector 11 and an output active power P are shown in Table 1.

**Table 1**

| Rated power of the PM | Scenario | Type of a power cable connected to the power system 10 | Status of an in-position signal pin | Second detection voltage | Active power P |
|---|---|---|---|---|---|
| 4 kW | Scenario 1 | 3 kW power cable or no cable connected | a-cp and b-cp of the fourth connector 41 are open-circuited | Vcc | P≤3 kW |
| | Scenario 2 | 4 kW power cable | a-cp of the fourth connector 41 is short-circuited, and b-cp of the fourth connector 41 is open-circuited | 0 | P≤4 kW |
| | Scenario 3 | 6 kW power cable | a-cp of the fourth connector 41 is open-circuited, and b-cp of the fourth connector 41 is short-circuited | Vcc/2 | P≤4 kW |
| 6 kW | Scenario 1 | 3 kW power cable or no cable connected | a-cp and b-cp of the fourth connector 41 are open-circuited | Vcc | P≤3 kW |
| | Scenario 2 | 4 kW power cable | a-cp of the fourth connector 41 is short-circuited, and b-cp of the fourth connector 41 is open-circuited | 0 | P≤4 kW |
| | Scenario 3 | 6 kW power cable | a-cp of the fourth connector 41 is open-circuited, and b-cp of the fourth connector 41 is short-circuited | Vcc/2 | P≤6 kW |

For FIG. 16b, the PM may identify types of two power cables in the dual power entry scenario and output an active power, thereby avoiding power cable overload. For a PM with a rated power of 4 kW and a PM with a rated power of 6 kW, when different types of power cables are connected, a second detection voltage acquired by the first sampling circuit AD1 from the first connector 11 and an output active power P are shown in Table 2.

**Table 2**

| Rated power of the PM | Scenario | Type of a power cable connected to the power system 10 | Status of an in-position signal pin | Second detection voltage | Active power P |
|---|---|---|---|---|---|
| 4 kW | Scenario 1 | 3 kW power cable or no cable connected | a-cp of the fourth connector 41 is open-circuited, b-cp of the fourth connector 41 is open-circuited, a-cp of the fourth connector 42 is open-circuited, and b-cp of the fourth connector 42 is open-circuited | Vcc | P≤3 kW |
| | Scenario 2 | 4 kW power cable | a-cp of the fourth connector 41 is short-circuited, and b-cp of the fourth connector 41 is open-circuited a-cp of the fourth connector 42 is short-circuited, and b-cp of the fourth connector 42 is open-circuited | 0 | P≤4 kW |
| | Scenario 3 | 6 kW power cable | a-cp of the fourth connector 41 is open-circuited, and b-cp of the fourth connector 41 is short-circuited a-cp of the fourth connector 42 is open-circuited, and b-cp of the fourth connector 42 is short-circuited | Vcc/2 | P≤4 kW |
| 6 kW | Scenario 1 | 3 kW power cable or no cable connected | a-cp of the fourth connector 41 is open-circuited, and b-cp of the fourth connector 41 is open-circuited a-cp of the fourth connector 42 is open-circuited, and b-cp of the fourth connector 42 is open-circuited | Vcc | P≤3 kW |
| | Scenario 2 | 4 kW power cable | a-cp of the fourth connector 41 is short-circuited, and b-cp of the fourth connector 41 is open-circuited a-cp of the fourth connector 42 is short-circuited, and b-cp of the fourth connector 42 is open-circuited | 0 | P≤4 kW |
| | Scenario 3 | 6 kW power cable | a-cp of the fourth connector 41 is open-circuited, and b-cp of the fourth connector 41 is short-circuited a-cp of the fourth connector 42 is open-circuited, and b-cp of the fourth connector 42 is short-circuited | Vcc/2 | P≤6 kW |

In Table 2, in the dual power entry scenario, types of the two power cables in the power system 10 are the same, and the power system 10 may run in a normal mode.

The power system 10 may further have an abnormal mode in which two power cables of different types are connected, as shown in Table 3. The following two cases are separately described.

Case 1: Two fourth connectors of the power system 10 are respectively connected to the power cables.

The power system 10 may output an active power based on a rated power of a power cable (that is, the first power cable) of a low power level (for example, 3 kW). Alternatively, the power system 10 may output an active power based on a rated power of a power cable (that is, the second power cable) of a high power level (for example, 4 kW), and send alarm information. The alarm information may indicate to replace the power cable of the high power level. It may be figured out that the rated power of the power cable of the low power level is less than the rated power of the power cable of the high power level.

**Table 3**

| Power supply type | Scenario | Type of a connected power cable | Status of an in-position signal pin | Second detection voltage | Active power P |
|---|---|---|---|---|---|
| 4 kW | Scenario 1 | One is connected to the 4 kW power cable, and one is connected to the 3 kW power cable | a-cp of the fourth connector 41 is short-circuited, and others are open-circuited; | One is Vcc, and one is 0 | Method 1: When P≤3 kW, alarm information is issued |
| | | | | | Method 2: When the power system 10 switches to the power supply connected to the 4 kW power cable, and P≤4 kW, alarm information is issued; |
| | | | or a-cp of the fourth connector 42 is short-circuited, and others are open-circuited | | and when the power supply connected to the 4 kW power cable is powered off, the power system 10 switches to the power supply connected to the 3 kW power cable, and P≤3 kW, alarm information is issued |
| | Scenario 2 | One is connected to the 6 kW power cable, and one is connected to the 3 kW power cable | b-cp of the fourth connector 41 is short-circuited, and others are open-circuited; or b-cp of the fourth connector 42 is short-circuited, and others are open-circuited | One is Vcc, and one is Vcc/2 | Method 1: When ≤3 kW, alarm information is issued |
| | | | | | Method 2: When the power system 10 switches to the power supply connected to the 6 kW power cable, and P≤4 kW, alarm information is issued; and when the power supply connected to the 6 kW power cable is powered off, the power system 10 switches to the power supply connected to the 3 kW power cable, and P≤3 kW, alarm information is issued |
| | Scenario 3 | One is connected to the 4 kW power cable, and one is connected to the 6 kW power cable | a-cp of the fourth connector 41 is short-circuited, and b-cp of the fourth connector 42 is short-circuited; or b-cp of the fourth connector 41 is short-circuited, and a-cp of the fourth connector 42 is short-circuited | One is Vcc/2, and one is 0 | P≤4 kW |
| 6 kW | Scenario 1 | One is connected to the 4 kW power cable, and one is connected to the 3 kW power cable | a-cp of the fourth connector 41 is short-circuited, and others are open-circuited; or a-cp of the fourth connector 42 is short-circuited, and others are open-circuited | One is Vcc, and one is 0 | Method 1: When P≤3 kW, alarm information is issued |
| | | | | | Method 2: When the power system 10 switches to the power supply connected to the 4 kW power cable, and P≤4 kW, alarm information is issued; and when the power supply connected to the 4 kW power cable is powered off, the power system 10 switches to the power supply connected to the 3 kW power cable, and P≤3 kW, alarm information is issued |
| | Scenario 2 | One is connected to the 6 kW power cable, and one is connected to the 3 kW power cable | b-cp of the fourth connector 41 is short-circuited, and others are open-circuited; or b-cp of the second connector 42 is short-circuited, and others are open-circuited | One is Vcc, and one is Vcc/2 | Method 1: When P≤3 kW, alarm information is issued |
| | | | | | Method 2: When the power system 10 switches to the power supply connected to the 6 kW power cable, and P≤6 kW, alarm information is issued; and when the power supply connected to the 6 kW power cable is powered off, the power system 10 switches to the power supply connected to the 3 kW power cable, and P≤3 kW, alarm information is issued |
| | Scenario 3 | One is connected to the 4 kW power cable, and one is connected to the 6 kW power cable | a-cp of the fourth connector 41 is short-circuited, and b-cp of the fourth connector 42 is short-circuited; or b-cp of the fourth connector 41 is short-circuited, and a-cp of the fourth connector 42 is short-circuited | One is Vcc/2, and one is 0 | Method 1: P≤4 kW |
| | | | | | Method 2: When the power system 10 switches to the power supply connected to the 6 kW power cable, and P≤6 kW, alarm information is issued; and when the power supply connected to the 6 kW power cable is powered off, the power system 10 switches to the power supply connected to the 4 kW power cable, and P≤4 kW, alarm information is issued |

Case 2: One of the fourth connectors of the power system 10 is connected to a power cable, and the other fourth connector is not connected to a power cable.

The connected power cable may be identified, and the fourth connector that is not connected to the power cable may determine, by identifying whether the power pin of the power cable is in position, whether the power system 10 is a single-entry system, and if yes, prompt information is sent. The prompt information indicates that another power cable needs to be plugged in.

It can be learned from the foregoing embodiments that, in this application, types of power cables with different through-current capabilities may be identified through a PM or through both a PM and a PEM, and an active power output by the power system 10 may further be determined based on the type of the power cable. In this embodiment of this application, the third voltage divider resistor R3 may be disposed in the single power entry scenario, the third voltage divider resistor R3 and the fourth voltage divider resistor R5 may be disposed in the dual power entry scenario, or different voltage sources may be disposed, so that the sampling circuit can acquire different second detection voltages, thereby implementing identification of a type of a power cable. Certainly, only several possible implementations are described above. This embodiment of this application may further include another implementation, and details are not described.

It may be understood that, in this embodiment of this application, the power system including the first connector (including two or three signal pins) may be used to identify a type of a power cable including the second connector (including two or three signal pins). It can be figured out that, in this embodiment of this application, the first connector including more signal pins such as four or five signal pins may further be used to identify different types of power cables including more signal pins (such as short-circuit pins or jumper pins). In other words, in this embodiment of this application, different types of power cables can be compatible, and differentiation of a plurality of power cables can be supported.

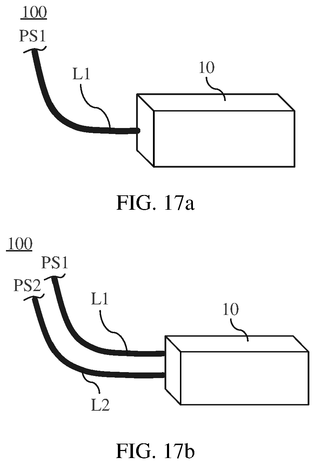

An embodiment of this application further provides a network device, as shown in FIG. 17a and FIG. 17b.

In FIG. 17a, a network device 100 may include the power cable L1 and the power system 10. The power system 10 may be connected to the power cable L1, and the power cable L1 may be connected to the power supply PS1.

In FIG. 17b, a network device 100 may include the power cable L1, the power cable L2, and the power system 10. The power system 10 may be connected to the power cable L1, and the power system 10 may further be connected to the power cable L2. The power cable L1 may be connected to the power supply PS1, and the power cable L2 may be connected to the power supply PS2.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power system, comprising a power module, wherein the power module comprises a voltage source, a sampling circuit, and a first connector, and the first connector is configured to connect to a power cable;
the voltage source is configured to provide a first detection voltage for the first connector; and
the sampling circuit is configured to: acquire a second detection voltage from the first connector, and identify a type of the power cable based on the second detection voltage.

2. The power system according to claim 1, wherein the first connector comprises a first signal pin and a second signal pin; or the first connector comprises a first signal pin, a second signal pin, and a third signal pin;
the power cable comprises a second connector, and the second connector is configured to connect to the first connector; and
the second connector is configured to: short-circuit the first signal pin and the second signal pin, or short-circuit the second signal pin and the third signal pin.

3. The power system according to claim 2, wherein
when the power system is configured to identify a type of a single power cable, the power module further comprises a first voltage divider resistor, wherein a first end of the first voltage divider resistor is connected to the voltage source, a second end of the first voltage divider resistor is connected to the sampling circuit, the second end of the first voltage divider resistor is connected to the second connector through the first signal pin of the first connector, and the second signal pin of the first connector is connected to the second connector and is connected to a ground terminal; or
when the power system is configured to identify types of a plurality of power cables, the power module comprises a plurality of first connectors and a plurality of sampling circuits, the plurality of power cables comprise a plurality of second connectors, and the power module further comprises a first voltage divider resistor and a second voltage divider resistor, wherein respective first ends of the first voltage divider resistor and the second voltage divider resistor are connected to the voltage source; a second end of the first voltage divider resistor is connected to a first sampling circuit in the plurality of sampling circuits, and the second end of the first voltage divider resistor is further connected to one of the second connectors through a first signal pin of one of the first connectors; a second end of the second voltage divider resistor is connected to a second sampling circuit in the plurality of sampling circuits, and the second end of the second voltage divider resistor is further connected to another second connector through a first signal pin of another first connector; and a second signal pin of the one of the first connectors is connected to the one of the second connectors, a second signal pin of the another first connector is connected to the another second connector, and a second signal pin of each first connector is connected to the ground terminal.

4. The power system according to claim 3, wherein
when the power system is configured to identify a type of a single power cable, the power module further comprises a third voltage divider resistor, wherein a first end of the third voltage divider resistor is connected to the sampling circuit, the first end of the third voltage divider resistor is connected to the second connector through the first signal pin of the first connector, and a second end of the third voltage divider resistor is connected to the second connector through the third signal pin of the first connector; or the first end of the third voltage divider resistor is connected to the second connector through the third signal pin of the first connector, and a second end of the third voltage divider resistor is connected to the second connector through the first signal pin of the first connector; or
when the power system is configured to identify types of a plurality of power cables, the power module further comprises a third voltage divider resistor and a fourth voltage divider resistor, wherein a first end of the third voltage divider resistor is connected to the first sampling circuit, the first end of the third voltage divider resistor is further connected to one of the second connectors through a first signal pin of one of the first connectors, and a second end of the third voltage divider resistor is connected to the one of the second connectors through a third signal pin of the one of the first connectors; or the first end of the third voltage divider resistor is further connected to one of the second connectors through a third signal pin of one of the first connectors, and a second end of the third voltage divider resistor is connected to the one of the second connectors through a first signal pin of the one of the first connectors; and a first end of the fourth voltage divider resistor is connected to the second sampling circuit, the first end of the fourth voltage divider resistor is further connected to another second connector through a first signal pin of another first connector, and a second end of the fourth voltage divider resistor is connected to the another second connector through a third signal pin of the another first connector; or the first end of the fourth voltage divider resistor is further connected to another second connector through a third signal pin of another first connector, and a second end of the fourth voltage divider resistor is connected to the another second connector through a first signal pin of the another first connector.

5. The power system according to claim 2, wherein
when the power system is configured to identify a type of a single power cable, the power module comprises a plurality of sampling circuits, and the power module further comprises a first voltage divider resistor and a second voltage divider resistor, wherein respective first ends of the first voltage divider resistor and the second voltage divider resistor are connected to the voltage source; a second end of the first voltage divider resistor is connected to a first sampling circuit in the plurality of sampling circuits, and the second end of the first voltage divider resistor is further connected to the second connector through the first signal pin of the first connector; a second end of the second voltage divider resistor is connected to a second sampling circuit in the plurality of sampling circuits, and the second end of the second voltage divider resistor is further connected to the second connector through the third signal pin of the first connector; and the second signal pin of the first connector is connected to the second connector and is connected to a ground terminal; or
when the power system is configured to identify types of a plurality of power cables, the power module comprises a plurality of first connectors and a plurality of sampling circuits, the plurality of power cables comprise a plurality of second connectors, and the power module further comprises a first voltage divider resistor, a second voltage divider resistor, a fifth voltage divider resistor, and a sixth voltage divider resistor, wherein respective first ends of the first voltage divider resistor, the second voltage divider resistor, the fifth voltage divider resistor, and the sixth voltage divider resistor are connected to the voltage source; a second end of the first voltage divider resistor is connected to a first sampling circuit in the plurality of sampling circuits, and the second end of the first voltage divider resistor is further connected to one of the second connectors through a first signal pin of one of the first connectors; a second end of the second voltage divider resistor is connected to a second sampling circuit in the plurality of sampling circuits, and the second end of the second voltage divider resistor is further connected to the one of the second connectors through a third signal pin of the one of the first connectors; a second signal pin of the one of the first connectors is connected to the one of the second connectors and is connected to the ground terminal; a second end of the fifth voltage divider resistor is connected to a third sampling circuit in the plurality of sampling circuits, and the second end of the fifth voltage divider resistor is further connected to another second connector through a first signal pin of another first connector; a second end of the sixth voltage divider resistor is connected to a fourth sampling circuit in the plurality of sampling circuits, and the second end of the sixth voltage divider resistor is further connected to the another second connector through a third signal pin of the another first connector; and a second signal pin of the another first connector is connected to the another second connector and is connected to the ground terminal.

6. The power system according to claim 4 or 5, wherein the power system further comprises a power entry module, and the power entry module comprises a third connector and a fourth connector; and
the third connector is configured to connect to the first connector, and the fourth connector is configured to connect to the second connector.

7. The power system according to claim 2, wherein the power system further comprises a power entry module; and
when the power system is configured to identify a type of a single power cable, the power entry module comprises a third connector and a fourth connector, and the power module further comprises a first voltage divider resistor, wherein a first end of the first voltage divider resistor is connected to the voltage source, a second end of the first voltage divider resistor is connected to the sampling circuit, and the second end of the first voltage divider resistor is further connected to the first signal pin of the first connector; the first signal pin of the first connector is connected to the second connector through a first signal pin of the third connector and a first signal pin of the fourth connector; and the second signal pin of the first connector is connected to the second connector through a second signal pin of the third connector and a second signal pin of the fourth connector, and the second signal pin of the first connector is connected to a ground terminal; or
when the power system is configured to identify types of a plurality of power cables, the power entry module comprises a third connector and a plurality of fourth connectors, the power module comprises a plurality of sampling circuits, the plurality of power cables comprise a plurality of second connectors, and the power module further comprises a first voltage divider resistor and a second voltage divider resistor, wherein respective first ends of the first voltage divider resistor and the second voltage divider resistor are connected to the voltage source; a second end of the first voltage divider resistor is connected to a first sampling circuit in the plurality of sampling circuits, the second end of the first voltage divider resistor is further connected to the first signal pin of the first connector, a second end of the second voltage divider resistor is connected to a second sampling circuit in the plurality of sampling circuits, and the second end of the second voltage divider resistor is further connected to the third signal pin of the first connector; the first signal pin of the first connector is connected to one of the second connectors through a first signal pin of the third connector and a first signal pin of one of the fourth connectors; the third signal pin of the first connector is connected to the another second connector through a third signal pin of the third connector and a first signal pin of another fourth connector; the second signal pin of the first connector is connected to a second signal pin of the third connector and is connected to the ground terminal; and the second signal pin of the third connector is connected to the one of the second connectors through a second signal pin of the one of the fourth connectors, and the second signal pin of the third connector is further connected to another second connector through a second signal pin of the another fourth connector.

8. The power system according to claim 2, wherein the power system further comprises a power entry module; and
when the power system is configured to identify a type of a single power cable, the power entry module comprises a third connector and a fourth connector, the power module further comprises a first voltage divider resistor, and the power entry module further comprises a third voltage divider resistor, wherein the first voltage divider resistor is connected to the voltage source, a second end of the first voltage divider resistor is connected to the sampling circuit, the second end of the first voltage divider resistor is connected to a first signal pin of the third connector through the first signal pin of the first connector, and the second signal pin of the first connector is connected to a second signal pin of the third connector and is connected to the ground terminal; the third voltage divider resistor is connected between the first signal pin of the third connector and a third signal pin of the fourth connector, or the third voltage divider resistor is connected between the first signal pin of the third connector and a first signal pin of the fourth connector; the second signal pin of the third connector is connected to a second signal pin of the fourth connector; and the first signal pin, the second signal pin, and the third signal pin of the fourth connector are separately connected to the second connector; or
when the power system is configured to identify types of a plurality of power cables, the power entry module comprises a third connector and a plurality of fourth connectors, the power module comprises a plurality of sampling circuits, the plurality of power cables comprise a plurality of second connectors, the plurality of second connectors one-to-one correspond to the plurality of fourth connectors, the power module further comprises a first voltage divider resistor and a second voltage divider resistor, and the power entry module further comprises a third voltage divider resistor and a fourth voltage divider resistor, wherein respective first ends of the first voltage divider resistor and the second voltage divider resistor are connected to the voltage source, a second end of the first voltage divider resistor is connected to a first sampling circuit in the plurality of sampling circuits, and the second end of the first voltage divider resistor is further connected to a first signal pin of the third connector through the first signal pin of the first connector; a second end of the second voltage divider resistor is connected to a second sampling circuit in the plurality of sampling circuits, and the second end of the second voltage divider resistor is further connected to a third signal pin of the third connector through the third signal pin of the first connector; the second signal pin of the first connector is connected to a second signal pin of the third connector and is connected to the ground terminal; the third voltage divider resistor is connected between the first signal pin of the third connector and a third signal pin of one of the fourth connectors, or the third voltage divider resistor is connected between the first signal pin of the third connector and a first signal pin of one of the fourth connectors; the fourth voltage divider resistor is connected between the third signal pin of the third connector and a third signal pin of another fourth connector, or the fourth voltage divider resistor is connected between the third signal pin of the third connector and a first signal pin of the another fourth connector; the second signal pin of the third connector is connected to a second signal pin of the fourth connector; the first signal pin, a second signal pin, and the third signal pin of the one of the fourth connectors are connected to the one of the second connectors; and the first signal pin, a second signal pin, and the third signal pin of the another fourth connector are connected to the another second connector.

9. The power system according to any one of claims 2 to 8, wherein the first connector further comprises a first power pin;
a friction distance of the first signal pin, the second signal pin, or the third signal pin is less than a friction distance of the first power pin; and
the friction distance indicates a motion distance of a contact point of the first signal pin, the second signal pin, or the third signal pin.

10. The power system according to any one of claims 1 to 9, wherein when the power system is configured to identify the type of the single power cable, the power system is configured to:
when a rated power of the power cable is less than a rated power of the power module, output an active power based on the rated power of the power cable; or when a rated power of the power cable is greater than a rated power of the power module, output an active power based on the rated power of the power module.

11. The power system according to any one of claims 1 to 9, wherein when types of a first power cable and a second power cable in the plurality of power cables identified by the power system are different, the power system is configured to:
output an active power based on a rated power of the first power cable; or output an active power based on a rated power of the second power cable, and issue alarm information, wherein the rated power of the first power cable is less than the rated power of the second power cable, and the alarm information indicates to replace the first power cable.

12. The power system according to any one of claims 1 to 9, wherein when types of a first power cable and a second power cable in the plurality of power cables identified by the power system are the same, the power system is configured to:
when a rated power of the first power cable or the second power cable is less than a rated power of the power module, output an active power based on the rated power of the first power cable or the second power cable; or when a rated power of the first power cable or the second power cable is greater than a rated power of the power module, output an active power based on the rated power of the power module.

13. A network device, comprising a power cable and the power system according to any one of claims 1 to 12, wherein the power system is connected to the power cable.
